Europäisches Patentamt

European Patent Office

Office européen des brevets

(11) Publication number: **0 126 446**
**B1**

(12) **EUROPEAN PATENT SPECIFICATION**

(45) Date of publication of patent specification: **23.11.89**

(51) Int. Cl.⁴: **H 03 H 1/00, H 03 H 3/00**

(21) Application number: **84105637.7**

(22) Date of filing: **17.05.84**

(54) Noise filter and production method.

(30) Priority: **18.05.83 JP 85925/83**
**25.07.83 JP 134377/83**

(43) Date of publication of application:
**28.11.84 Bulletin 84/48**

(45) Publication of the grant of the patent:
**23.11.89 Bulletin 89/47**

(84) Designated Contracting States:
**DE FR GB**

(56) References cited:
**GB-A- 743 717**

**PATENTS ABSTRACTS OF JAPAN, vol. 3, no.
106 (E-135), 7th September 1979, page 124 E
135; & JP - A - 54 83 736 (MATSUSHITA DENKI
SANGYO K.K.) 07-04-1979**

(73) Proprietor: **Ikeda, Takeshi**
**5-6-213 Sanno-2**
**Ohta-Ku Tokyo 143 (JP)**

(72) Inventor: **Ikeda, Takeshi**
**5-6-213 Sanno-2**
**Ohta-Ku Tokyo 143 (JP)**

(74) Representative: **Patentanwälte TER MEER -
MÜLLER - STEINMEISTER**
**Mauerkircherstrasse 45**
**D-8000 München 80 (DE)**

Courier Press, Leamington Spa, England.

**Description**

This invention generally pertains to a noise filter and to a method of its production, and more specifically to a filter particularly suited for suppressing noise and ripple components in power supply and smoothing circuits.

Noise filters are generally used for preventing malfunctions of electronic equipment by noise transmitted thereto and superimposed with its power supply and for suppressing any noise generated in an equipment and transmitted to any other equipment or power supply.

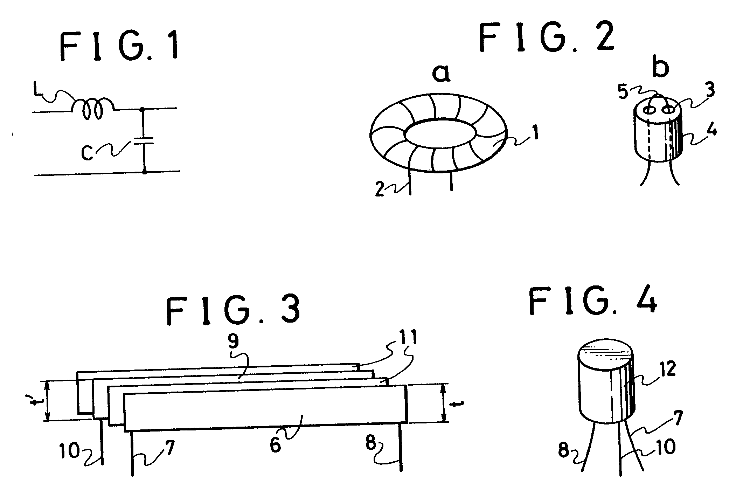

Hitherto, noise filters comprising inductance (L) connected in series with a power supply and shunt capacitance (C) as shown in Fig. 1 have been widely used for the above purposes.

The inductance L for use in such noise filter circuit takes various forms including a coil 2 wound around a magnetic core 1 such as a toroidal type ferrite core or a dust core as shown in Fig. 2a or a conductive wire 5 passing through openings 3 in a bead magnetic core 4 as shown in Fig. 2b.

A primary problem associated with the manufacturing of such noise filters is high production cost of the inductance L, especially pressing and heating processes of the magnetic core and winding of the coil in addition to connecting of the capacitor C.

Many attempts have been made to solve the problems and to provide less expensive noise filters. One effective approach is to integrate both inductive and capacitive elements into a single device and also to eliminate the need for the magnetic core. Japanese laid open patent application (Kokai) No. 9764/77 shows a power supply noise filter made of a metal foil wound in a spiral manner with a pair of lead wires connected at both ends to form the inductance L. Additionally, another metal foil is laminated with the first mentioned metal foil with an insulating separator therebetween to form a shunt capacitance. In Japanese utility model publication No. 24900/80 an improvement of such metal foil spiral inductance is described by adding external inductors to provide a bypass for the DC component. With these prior art measures, some of the problems associated with the conventional noise filters comprising discrete inductance and capacitance elements can be solved. However, the prior art integrated noise filters are not satisfactory because of a relatively low inductance.

Japanese laid open patent application (Kokai) No. 21810/82 discloses a technique to increase the spiral inductance by coating magnetic powder on one or both surfaces of the insulating film. However, this technique requires an additional process and is more expensive than the above mentioned prior art approach.

Noise filters according to the present invention provide for a larger inductance with a given size of the conductive foil by using an electromagnetically conductive film or foil as at least one of the metal films to be wound in a spiral manner with insulating separators. The electromagnetically conductive film in this specification means any thin material of good conductivity to electric current and magnetic flux. The electrically conductive film is placed so close to the electrically or electromagnetically conductive film over the entire length that the inductance of the spirally wound conductor is significantly increased in comparison to the prior art devices, thereby providing a required inductance without using a magnetic core or winding an undesirably long film while forming a capacitance distributed over the entire length.

It is therefore the primary object of this invention to provide a compact noise filter comprising series inductance and shunt capacitance integrated into a generally tubular form without using a magnetic core.

It is another object of this invention to provide a noise filter that can be fabricated essentially the same manner and the same production facility as a tubular capacitor.

It is yet another object of this invention to provide a noise filter with excellent noise suppression characteristic over a wide frequency range.

It is still another object of this invention to provide a noise filter requiring less number of turns for the winding of the inductor.

It is an additional object of this invention to provide a noise filter simpler and less expensive to manufacture.

These and other objects of this invention along with its operation and advantages will best understood from reading the following description of preferred embodiments of this invention by reference to the accompanying drawings.

Fig. 1 is a basic circuit of a conventional noise filter comprising discrete inductor and capacitor elements;

Fig. 2a and b are two typical prior art inductors to be used in the conventional noise filter of Fig. 1;

Fig. 3 is an expanded view of one embodiment of the invention;

Fig. 4 is a perspective view of one embodiment of a tubular noise filter according to the invention;

Figs. 5 through 8 are attenuation characteristic curves of different samples of two embodiments of the noise filter according to the invention in comparison to conventional noise filters;

Figs. 9 and 10 are attenuation characteristic curves of various samples to show how inductance and capacitance effect the overall characteristics.

Referring now to Fig. 3 illustrating an expanded view of the noise filter according to this invention, a good electrically conductive band 6 is made of copper or aluminum foil and includes lead wires 7 and 8 connected near to both ends of the band 6. Another electromagnetically conductive band 9 made of a thin sheet of iron or a similar material includes a lead wire 10 connected thereto and which conductive band 9 is disposed in superimposed relation with the electrically conductive band 6 with an insulation band 11 such as an insulation sheet or a capacitor paper between both bands 6 and 9. A stable iron sheet or film of uniform thickness is now available under terms like "galvanized electro-deposited iron foil". It should be noted, however, that the electrically conductive film may be other than iron as long as it exhibits excellent magnetic and electric conductivity. The whole sandwich arrangement is integrally wound in a tubular form as shown in Fig. 4, thereby providing a noise filter 12 with a capacitance distributed over the entire length of the coil. The entire noise filter may be pressed to an oval cross section before coating with a protective material.

The noise filter 12 thus formed comprises a coil of an electrically conductive band 6 between a pair of lead wires 7 and 8 and a capacitance distributed between the electrically conductive band 6 and the electromagnetically conductive band 9 over the entire length of the band 6. It should be noted that the electromagnetically conductive band 9 is sandwiched between electrically conductive band 6 with insulation spacer to increase the inductance of the coil. The conductive bands 6 and 9 may be provided directly on the respective insulating film by vapor deposition, non-electrolytic plating, sputtering or similar technique, thereby miniaturing the noise filter. Additionally the inductive coupling between both bands 6 and 9 aids to provide better noise suppression. Larger inductance values will result if the width t of band 6 is chosen to be smaller than the width t′ of band 9, thereby effectively burying band 6 when wound to a tubular form.

Another embodiment of this invention uses electromagnetically conductive bands such as iron films for both bands 6 and 9 in Fig. 3. This embodiment is essentially the same as the first embodiment except for the material of the film or band 6. As is understood from the description hereinafter, however, electrical performance of the second embodiment has been found to be superior to the first embodiment or prior art noise filters.

Now, noise suppression characteristic curve or frequency attenuation ratio characteristic curve of the noise filters according to this invention will be described hereunder in comparison with corresponding curves of conventional noise filters.

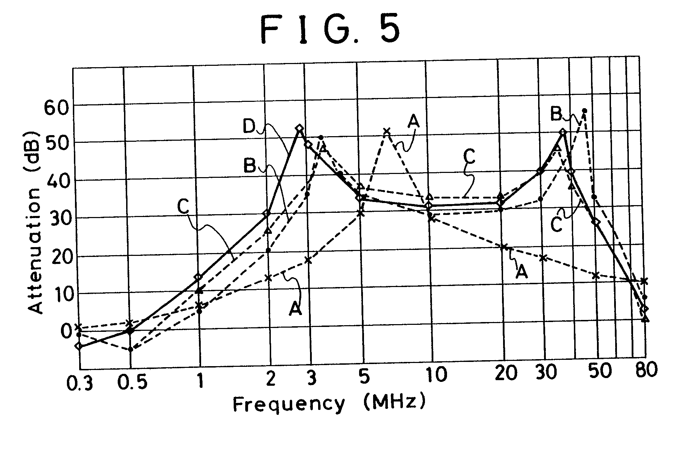

Fig. 5 shows four attenuation characteristic curves (in dB) against frequency of various noise filters in accordance with the test scheme of Japanese Industrial Standard (JIS-c6904-1977) for suppression effect test circuits applied for symmetrical noise signal voltages developed over a 50 Ω non-inductive (net equivalent) termination resistor connected to the output. The dotted line characteristic curve A represents the measuring values of a conventional noise filter as commercially available from TDK Corporation as product type ZBF253D-01 and comprising a series inductance L made of a bead core and a shunt Mylar capacitor C of approximately 0.01 μF connected as shown in Fig. 1. The known tested filter device had the dimensions of 4.8 mm in height and 6 mm for the long and 3 mm for the short diameters, respectively. Also, the dotted line characteristic curve B represents the measuring result of a prior art noise filter B comprising a good electrically conductive aluminum band of 12 mm width and about 55 μm thickness wound with sixteen turns to obtain essentially the same capacitance (≈0.01 μF) as that of the above sample A.

Represented by the characteristic curve C is the measuring result of a first embodiment of the noise filter according to this invention using an aluminum foil of 12 mm width and about 55 μm thickness as electrically conductive band 6 and an iron foil of 12 mm width and about 20 μm thickness as electromagnetically conductive band 9 both wound with seventeen turns with an appropriate insulating separator to obtain essentially the same capacitance (≈0.01 μF) as with the sample A. Also, represented by the solid line characteristic curve D, the measuring result of another embodiment of the noise filter according to this invention is plotted using 12 mm wide and about 20 μm thick iron foils as both electromagnetically conductive bands 6 and 9 wound with seventeen turns and an appropriate insulating separator to obtain a capacitance about 0.01 μF.

It is apparent from the characteristic curve in Fig. 5 that the attenuation factor of the sample A is the lowest of the four samples at low and high frequencies. Both characteristic curves C and D are generally better than those of the prior art noise filters at almost all frequencies.

Various samples with different parameters were made and tested for further demonstration of advantages of this invention in contrast to the prior art noise filters. The tested samples are as follows:

Sample A

This is the same as the aforementioned sample A, i.e. the commercially available noise filter ZBF253D-01 of TDK Corporation.

Sample B

A pair of non-magnetic, electrically conductive bands with 12 mm width and 20 μm of thickness were wound to a tubular form with a pair of 15 mm wide and 57 μm thick Mylar tapes leaving an air core of 4 mm in diameter. For three samples B-1, B-2 and B-3 a pair of 50 cm, 100 cm and 150 cm long aluminum foils were used and wound with 17, 28 and 38 turns, respectively.

Sample C

A 12 mm wide, 20 μm thick aluminum foil and iron foil of the same size were used as electrically conductive and electromagnetically conductive bands. Both bands were wound in a tubular form with a pair of 15 mm wide, 57 µm thick Mylar tapes therebetween leaving an air core of 4 mm in diameter. Three samples C-1, C-2 and C-3 use 50 cm, 100 cm and 150 cm long aluminum and iron foils were used and wound with 17, 28 and 38 turns, respectively.

Sample D

A pair of 12 mm wide, 20 µm thick iron foils were used as electromagnetically conductive foils 6 and 9 and were wound to a tubular form with a pair of 15 mm wide, 57 µm thick Mylar tapes therebetween leaving an air core of 4 mm in diameter. Three samples D-1, D-2 and D-3 use 50 cm, 100 cm and 150 cm long iron foils were used and wound with 17, 28 and 38 turns respectively.

The various electrical characteristics of these samples B, C and D are given in Table 1.

TABLE 1

| Sample | Material and size of foils and insulators | | Turns (length) | Inductance (µH) | Capacitance (µF) | Q |
|---|---|---|---|---|---|---|
| B-1 | Thickness: Width: | 20 µm 12 mm | 17 (50 cm) | 1.6 | 0.0038 | 0.07 |
| B-2 | Aluminum/aluminum insulator: | Mylar | 28 (100 cm) | 4.6 | 0.0077 | 0.14 |
| B-3 | Thickness: Width: | 57 µm 15 mm | 38 (150 cm) | 9.0 | 0.0191 | 0.22 |
| C-1 | Thickness: Width: | 20 µm 12 mm | 17 (50 cm) | 3.8 | 0.0038 | 0.18 |
| C-2 | Aluminum/iron insulator: | Mylar | 28 (100 cm) | 11.5 | 0.0079 | 0.37 |
| C-3 | Thickness: Width: | 57 µm 15 mm | 38 (150 cm) | 24.6 | 0.0187 | 0.59 |
| D-1 | Thickness: Width: | 20 µm 12 mm | 17 (50 cm) | 5.0 | 0.0038 | 0.11 |
| D-2 | Iron/iron insulator: | Mylar | 28 (100 cm) | 15.0 | 0.0081 | 0.18 |
| D-3 | Thickness: Width: | 57 µm 15 mm | 38 (150 cm) | 28.5 | 0.0176 | 0.23 |

Note:

Inductance, capacitance and Q factor were measured at 1 kHz.

As is apparent from the data in Table 1, both inductance and Q factor are larger for samples C and D using electromagnetically conductive films for at least one of the conductive bands 9 and 6 as compared with the prior art noise filters using only aluminum foils. However, the capacitance remains substantially unchanged.

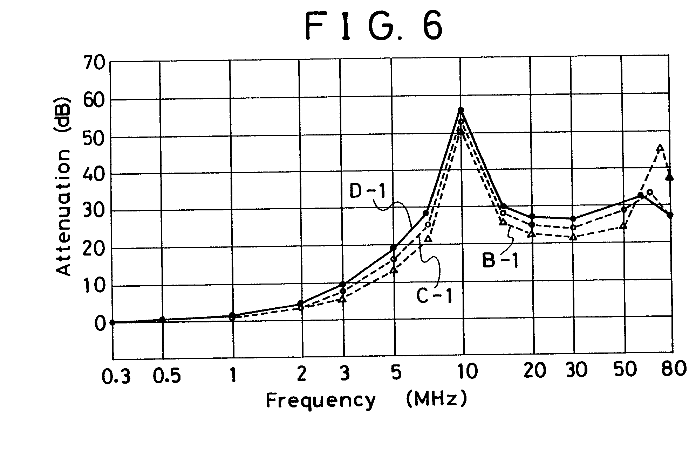

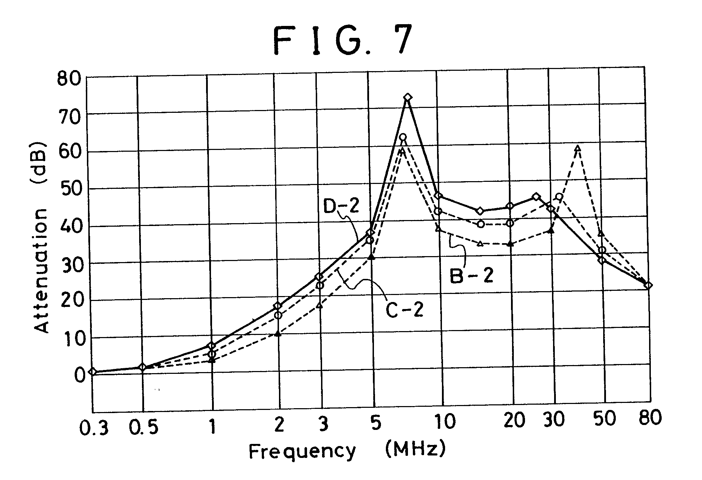

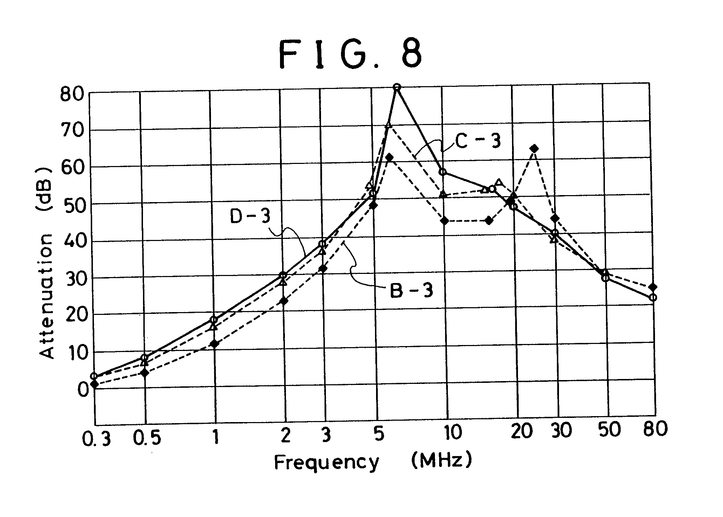

Then, the measuring of the frequency-attenuation characteristics of these samples were carried out. The test results are shown in Figs. 6 through 8, wherein sample reference number of the aforementioned samples are shown in the drawings.

It should be recognized that the samples had essentially the same number of turns of the windings and same size. Therefore, the differences in electrical performance are mainly responsible for the differences in materials of the conductive bands 6 and 9. The two embodiments according to this invention are generally superior in noise suppression properties over a wide frequency range. Especially, the sample D is better than any other samples.

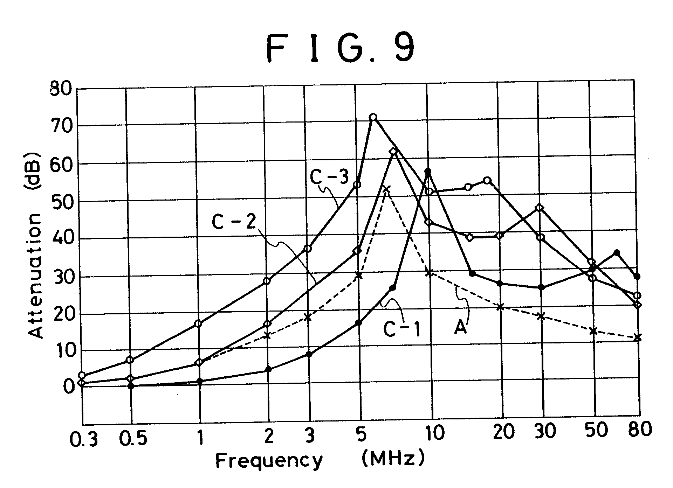

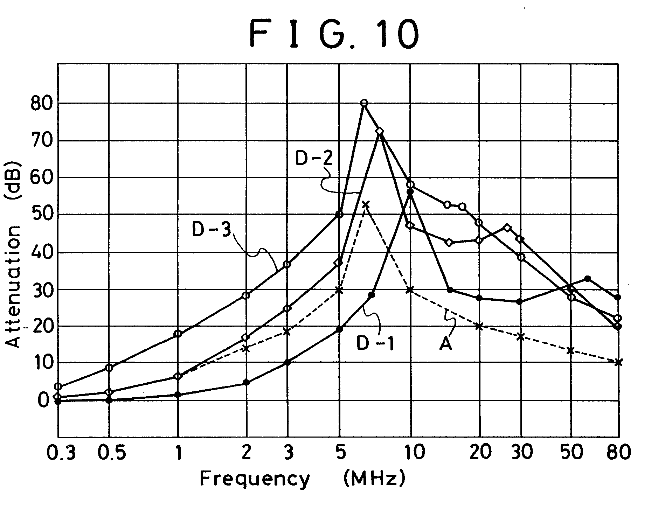

Figs. 9 and 10 each show characteristic curves of three samples C-1, C-2 and C-3 and D-1, D-2 and D-3 to demonstrate the effect of noise suppression due to different turns of the windings. It can be said that the noise filter performance is improved over a wide frequency range as the number of turns increases. The difference is significant at low frequencies. That is, the attenuation factor increases at low frequencies with large turns of the windings. Also shown in Figs. 9 and 10 are the characteristic curves of the conventional sample A to demonstrate the advantage of the present invention over the prior art noise filter composed of discrete elements.

As is understood from the foregoing description and test results, the present invention modifies the conventional tubular capacitors in respect to the material of the conductive foil, thereby providing samples, compact, and less expensive noise filters with excellent noise suppression characteristic over wide frequency ranges. The noise filter can be made in large quantity by using conventional production facility with essentially no additional technique.

Although I have described and demonstrated only preferred embodiments of this invention, the scope of this invention should not be limited to such embodiments. A person skilled in the art can easily modify this invention to best find his or her particular applications without departing from the scope of this invention. For example, the width of the conductive bands and the thickness of the insulating separators can be chosen depending on the current flowing through the coil and the applied voltage. The electromagnetically conductive film may be amorphous iron or MU-metal, or a lamination of electrically conductive and magnetically conductive layers. The noise filters find wide appreciations and a plurality of filters can be connected in cascade manner to provide higher noise attenuation. Such a multiple noise filter arrangement may be integrated in a single device.

## Claims

1. A noise filter comprising a pair of electrically conductive foils (6, 9) wound in a spiral manner with insulating separators (11) therebetween having at least three terminals (7, 8, 10), two (7, 8) connected to both ends of one (6) of said conductive foils and a third (10) to somewhere of the other conductive foil (9), characterized by the use of an electromagnetically conductive material for at least said other conductive foil (9).

2. The noise filter in accordance with claim 1 wherein said other conductive foil is made of an iron foil.

3. The noise filter in accordance with claim 1 wherein said electromagnetically conductive foil (9) is wider than said one conductive foil (6).

4. The noise filter in accordance with claim 1 wherein said noise filter has an essentially tubular form with an oval cross section.

5. The noise filter in accordance with claim 1 wherein said both conductive foils (6, 9) are made of an electromagnetically conductive material.

6. A method of making a noise filter comprising the steps of:
laminating an electrically conductive film (6) having a lead wire (7) at one end, an insulative film (11), an electromagnetically conductive film (9) having a lead wire (10) and another insulative film (11);
winding said lamination in a spiral manner around a core;
connecting another lead wire (8) to the other end of said electrically conductive film (6); and
coating the entire filter assembly with a protective material.

7. The method of making the noise filter in accordance with claim 6 further including the step of pressing said wound lamination in an oval cross section before said coating step.

8. The method of making the noise filter in accordance with claim 6, wherein said both conductive films (6, 9) are of an electromagnetically conductive material.

## Patentansprüche

1. Rauschfilter mit:
einem Paar elektrisch leitender Folien (6, 9), die spiralförmig mit dazwischen angeordneten isolierenden Trennschichten (11) gewickelt sind,
mindestens drei Anschlüssen (7, 8, 10), von denen zwei (7, 8) an den beiden Enden der einen (6) der leitenden Folien und der dritte (10) irgendwo an der anderen leitenden Folie (9) angeschlossen sind, gekennzeichnet durch die Verwendung eines elektromagnetisch leitenden Materials für mindestens diese andere leitende Folie (9).

2. Rauschfilter nach Anspruch 1, bei dem die andere leitende Folie eine Eisenfolie ist.

3. Rauschfilter nach Anspruch 1, bei dem die elektromagnetisch leitende Folie (9) breiter als die eine leitende Folie (6) ist.

4. Rauschfilter nach Anspruch 1, bei dem das Rauschfilter im wesentlichen röhrenförmig mit einem ovalen Querschnitt ausgebildet ist.

5. Rauschfilter nach Anspruch 1, bei dem beide leitenden Folien (6, 9) aus einem elektromagnetisch leitenden Material hergestellt sind.

6. Verfahren zur Herstellung eines Rauschfilters mit den Verfahrensschritten:
schichtweises Herstellen eines elektrisch leitenden Films (6) mit einem Zuleitungsdraht (7) an einem Ende, eines Isolierfilms (11), eines elektromagnetisch leitenden Films (9) mit einem Zuleitungsdraht (10) und eines weiteren Isolierfilms (11);
spiralförmiges Wickeln des Laminats um einen Kern;
Anschließen eines weiteren Zuleitungsdrahts (8) am anderen Ende des elektrisch leitenden Films (6); und

Ummanteln der gesamten Filteranordnung mit einem schützenden Material.

7. Verfahren zur Herstellung eines Rauschfilters nach Anspruch 6, mit dem zusätzlichen Verfahrensschritt:

Pressen des gewickelten Laminats in eine Form mit ovalem Querschnitt vor dem Verfahrensschritt Ummanteln.

8. Verfahren zur Herstellung eines Rauschfilters nach Anspruch 6, bei dem beide leitenden Filme (6, 9) aus einem elektromagnetisch leitendem Material hergestellt sind.

**Revendications**

1. Filtre anti-parasites comportant une paire de feuilles métalliques électriquement conductrices (6, 9) enroulées en spirale avec des séparateurs isolants (11) entre elles possédant au moins trois bornes (7, 8, 10), deux (7, 8) reliées aux deux extrémités d'une (6) desdites feuilles conductrices et une troisième (10) à un endroit quelconque de l'autre feuille de métal conductrice (9), caractérisé par l'utilisation d'un matériau électromagnétiquement conducteur pour au moins ladite autre feuille de métatl conductrice (9).

2. Filtre anti-parasites selon la revendication 1, dans lequel ladite autre feuille de métal conductrice est constituée d'une feuille de fer.

3. Filtre anti-parasites selon la revendication 1, dans lequel ladite feuille électromagnétiquement conductrice 9) est plus large que ladite première feuille conductrice (6).

4. Filtre anti-parasites selon la revendication 1, dans lequel ledit filtre anti-parasites possède une forme essentiellement tubulaire avec une section ovale en coupe.

5. Filtre anti-parasites selon la revendication 1, dans lequel lesdites feuilles de métal conductrices (6, 9) sont réalisées en un matériau électromagnétiquement conducteur.

6. Procédé de fabrication d'un filtre anti-parasites comportant les étapes consistant à:

empiler une pellicule électriquement conductrice (6) possédant un fil de connexion (7) à une extrémité, une pellicule isolante (11), une pellicule électromagnétiquement conductrice (9) possédant un fil de connexion (10) et une autre pellicule isolante (11);

enrouler ledit empilement en spirale autour d'un noyau;

relier un autre fil de connexion (8) à l'autre extrémité de ladite pellicule électriquement conductrice (6); et

revêtir l'assemblage tout entier du filtre d'un matériau protecteur.

7. Procédé de fabrication du filtre anti-parasites selon la revendication 6, comprenant en outre l'étape consistant à presser ledit empilement enroulé pour lui donner une forme ovale en coupe avant ladite étape de revêtement.

8. Procédé de fabrication du filtre anti-parasites selon la revendication 6, dans lequel lesdites deux pellicules conductrices (6, 9) sont en un matériau électromagnétiquement conducteur.

FIG. 1

FIG. 2

FIG. 3

FIG. 4

EP 0 126 446 B1

# F I G. 5

EP 0 126 446 B1

# FIG. 6

# F I G. 7

F I G. 8

EP 0 126 446 B1

# F I G. 9

EP 0 126 446 B1

F I G. 10